# EUROPEAN PATENT APPLICATION

(11) **EP 2 618 484 A2**
(43) Date of publication of application: **24.07.2013**
(21) Application number: 13152246.8
(22) Date of filing: 22.01.2013
(51) Int. Cl.: H03G 3/30, H03G 5/00, H03G 5/16

(54) **Audio adjustment device and television receiving device providing the same**

(30) Priority: 23.01.2012 JP 2012011472
(71) Applicant: Funai Electric Co., Ltd., Daito-shi Osaka 574-0013 (JP)
(72) Inventor: Higashi, Norihiro, OSAKA, Osaka 574-0013 (JP); Nishimura, Keita, OSAKA, Osaka 574-0013 (JP); Eto, Kentaro, OSAKA, Osaka 574-0013 (JP); Ishihara, Hidetoshi, OSAKA, Osaka 574-0013 (JP); Tsukamoto, Keisuke, OSAKA, Osaka 574-0013 (JP)
(74) Representative: Giovannini, Francesca

(57) **Abstract**

An audio adjustment device (4) including a plurality of filters (43) respectively amplifying or attenuating signal components of a multiplicity of frequency bands among input audio components, an adjustment part (44) that adjusts gain characteristics of the plurality of filters (43), and a characteristic display part (5) that displays gain characteristics adjusted by the adjustment part (44). The adjustment part (44) is capable of independently adjusting gain in signal components of central frequencies (fr) of signal components subject to amplification or attenuation by the filters (43), and Q value of gain characteristics (G2) of the filters (43). The characteristic display part (5) displays the gain characteristics (G2) of the plurality of filters (43) in a row along one frequency axis (L1).

## Description

### Field of Technology

The present invention relates to an audio adjustment device adjusting the characteristics of gain relative to frequency, and a television receiving device providing the same.

### Background of the Invention

A previously known device, the parametric equalizer, is one type of audio adjustment device, comprising filter(s) that amplify or attenuate signal components of a given frequency band of an audio signal, and a display device showing a characteristic graph showing said filters' characteristics of gain versus frequency, and a mouse for the purpose of moving a cursor over a graph of characteristics displayed on said display device, and a CPU changing the gain characteristics of filter(s) according to movement of a cursor by means of operation of said mouse. In such a parametric equalizer, the frequency and gain are shown respectively on the horizontal axis and vertical axis of the characteristic graph. Also, the gain can be changed with respect to the central frequency of a filter by using a cursor on the characteristic graph to select the vicinity of the central frequency of a gain characteristic and moving the cursor vertically. In addition, by using the cursor to select an area slightly apart from the central frequency, and moving the cursor horizontally, the frequency band of signal components subject to amplification or attenuation by the filter can be made wider or narrower, changing the Q value of the filter (see for example, Cited Document 1). Because in such a parametric equalizer, the characteristic graph is displayed on a display device, the user is able to directly ascertain the gain characteristics (gain and Q-value with respect to central frequency) of the filters. Also, the user is able to change gain characteristics while viewing the characteristic graph and thus the operation of making changes is simple.

Also, in such a parametric equalizer, it is possible to adjust the gain in multiple frequency bands of a signal, and therefore parametric equalizers are known whereby a multiplicity of filters of differing central frequencies is provided and gain characteristics of said filters are displayed, and gain characteristics are switched and displayed for each filter (see for example Cited Document 2).

However in such a parametric equalizer, the user is only able to visually confirm gain characteristics for each filter at a time, and therefore it is difficult to ascertain the balance of gain characteristics among all filters, and it is difficult to ascertain the volume balance of each frequency band in the audio signal after adjustment by means of the equalizer.

In addition to the above, audio adjustment devices that display filter Q values numerically are known (see for example Cited Documents 3, 4).

### Cited Documents from Prior Art

### Patent Documents

Cited Document 1 Patent Laid-open Announcement H02(1991)-117202
Cited Document 2 Patent Laid-open Announcement H09(1997)-101179
Cited Document 3 Patent Laid-open Announcement H07(1995)-022882
Cited Document 4 Patent Laid-open Announcement 2010-140115

### Summary of the Invention

One or more embodiments of the present invention provide an audio adjustment device and television receiver providing the same, whereby in an audio adjustment device equipped with a multiplicity of filters, the user can recognize the gain and Q-value of each filter intuitively, and can adjust the gain and Q value simply, and also can easily ascertain the balance of gain characteristics among all filters.

In one aspect, an audio adjustment device according to one or more embodiments of the present invention includes a plurality of filters respectively amplifying or attenuating signal components of a multiplicity of frequency bands among input audio components, an adjustment part that adjusts gain characteristics of the plurality of filters, and a characteristic display part that displays gain characteristics adjusted by the adjustment part. The adjustment part is capable of independently adjusting gain in signal components of central frequencies of signal components subject to amplification or attenuation by the filters, and Q value of gain characteristics of the filters. The characteristic display part displays the gain characteristics of the plurality of filters in a row along one frequency axis.

In one or more embodiments, the characteristics display part displays the gain characteristics in dot format, dots contained within an area between gain characteristic curves of each of the filters and the frequency axis are displayed in a different color than dots outside said area, and dots indicating gain with respect to the central frequencies are assigned a given color whereas dots indicating gain with respect to frequencies other than the central frequencies are assigned a same color with a different intensity than the dots of central frequency, or are assigned a separate color than dots of the central frequencies.

Also, a television receiver according to one or more embodiments of the present invention includes the audio adjustment device and a video display part displaying video on the basis of an input video signal, whereby the video display part is also used as the characteristic display part.

According to one or more embodiments of the present invention, it is possible for the user to directly recognize gain and Q values for each filter from gain characteristics for each filter displayed on the characteristic display part. Also, adjustment operation is made simple, by making it possible to adjust gain and Q values using the adjustment part while viewing said displayed gain characteristics.

### Brief Description of the Drawings

Figure 1 is a front view of a television receiver according to one embodiment of the present invention,
Figure 2 is an electrical block diagram of said television receiver,
Figure 3 is a graph of filter gain characteristics displayed on the display of said television receiver,
Figure 4 is a drawing showing the change in appearance of said gain characteristics according to gain adjustment and Q value adjustment, and
Figure 5 is a graph of filter gain characteristics in a television receiver according to another example of the aforementioned embodiment.

### Detailed Description of Embodiments of the Invention

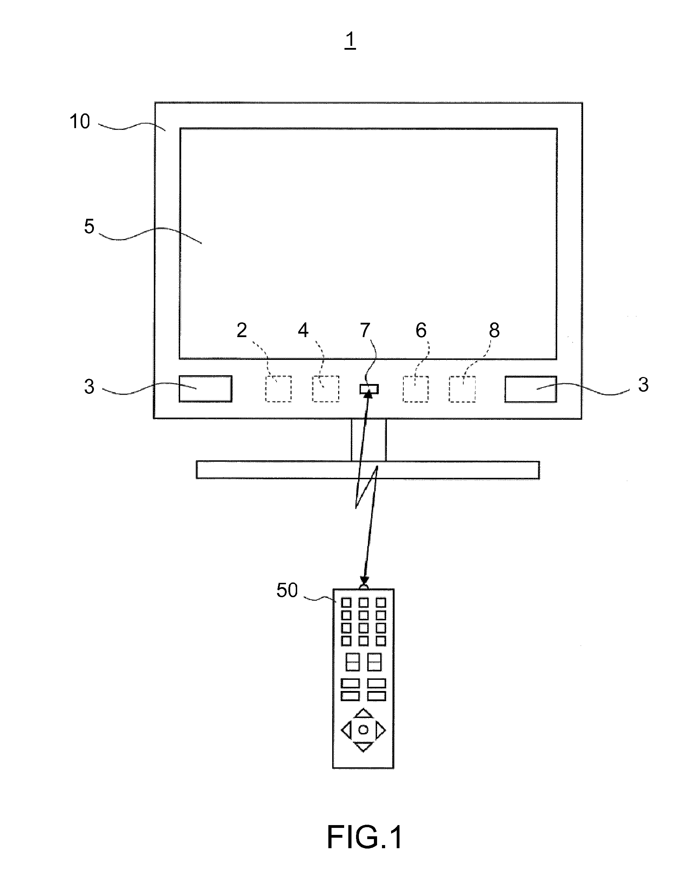

Next we describe a television ("TV") receiver equipped with an audio adjustment device according to one embodiment of the present invention, with reference to the drawings. Figure 1 shows the overall constitution of such a TV receiver. A TV receiver 1 is equipped with a TV receiver body 10, and a remote controller 50 for the purpose of remote operation of TV receiver body 10 by wireless communication.

TV receiver body 10 is comprised of a broadcast receiving circuit 2 (broadcast receiving part) receiving a digital TV broadcast signal (hereinafter simply referred to as "broadcast signal"), a speaker 3 outputting audio from TV broadcast programs (hereinafter simply referred to as "broadcast program") on the basis of audio signals in broadcast signals received by broadcast receiving circuit 2, an audio adjustment device 4 adjusting frequency characteristics of audio output from speaker 3, a display 5 (video display part) displaying the video image of broadcast programs on the basis of video signals in broadcast signals received by broadcast receiving circuit 2, and a display driver circuit 6 driving display 5.

TV receiver body 10 is also equipped with a receiver circuit 7 receiving operating signals from remote controller 50, and a control circuit 8. Control circuit 8 performs receiving control for broadcast receiving circuit 2 based on operating signals received from receiving circuit 7, as well as audio adjustment control for audio adjustment device 4, and display control for display 5 through display driver circuit 6.

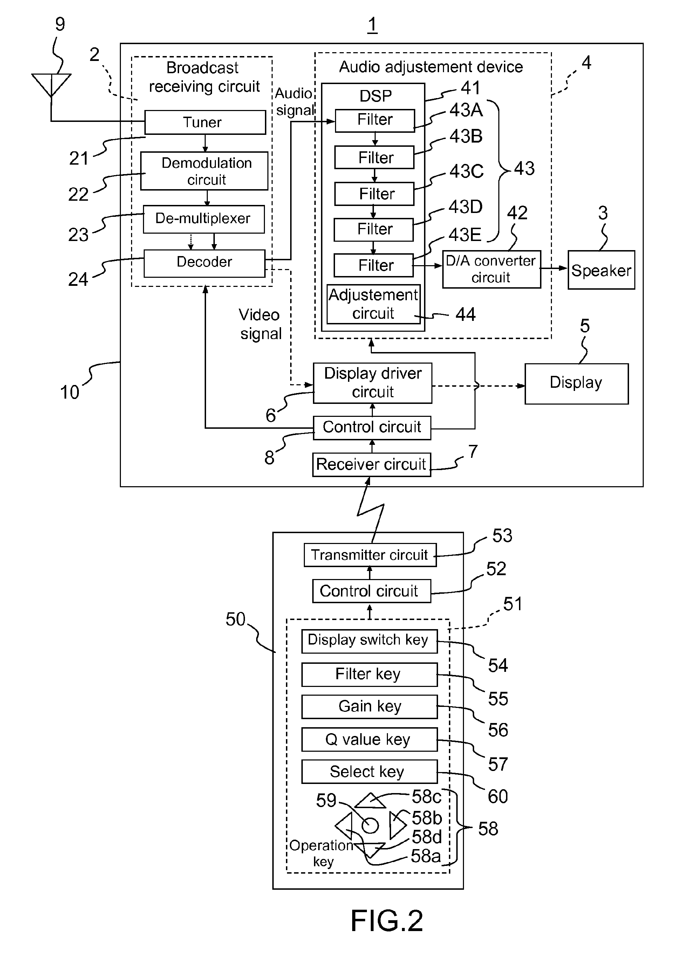

Figure 2 shows the detailed configuration of TV circuit 1. Broadcast receiving circuit 2 selects the channel of the broadcast signal received through an antenna 9, a tuner 21 receiving the broadcast signal on the selected channel, a demodulation circuit 22 demodulating the broadcast signal received by tuner 21, a demultiplexer 23 respectively separating the video signal and audio signal from the broadcast signal demodulated by demodulation circuit 22, and a decoder 24 respectively decoding the video signals and audio signals separated by demultiplexer 23.

Audio adjustment device 4 comprises a DSP (digital signal processor) 41 adjusting frequency characteristics of audio signals input after decoding by a decoder 24, a D/A conversion circuit 42 performing D/A conversion of audio signals after adjustment by DSP 41.

DSP 41 comprises 5-stage digital filters (hereinafter simply "filters") 43A-43E (collectively referred to as "filters 43") connected in series , and an adjustment circuit 44 (constituting the adjustment part), and adjusts gain characteristics of each filter of filters 43 based on operating signals from remote controller 50. The filters 43 are not specifically limited to the number shown in the drawing, and may be in any number.

Each filter 43 has both an attenuation function attenuating the audio signal and an amplification function amplifying the audio signal, and performs attenuation or amplification on an signal within a broadcast signal received by broadcast receiving circuit 2, decoded by decoder 24. Filters 43 (filters 43A through 43E) respectively amplify or attenuate signal components of five frequency bands within the audio signal after decoding, input from decoder 24, and the central frequencies of signal components that are amplified or attenuated are set so as not to overlap. The central frequencies of each filter 43 are, in order from filter 43A to 43E, 120 Hz, 500 Hz, 1.5 kHz, 5 kHz, 10kHz.

Each filter 43 is configured with, for example, the configuration of an IIR (infinite impulse response) filter, so as to enable changing of the gain of the signal component of the central frequency of signal components that it amplifies or attenuates (hereinafter simply referred to as the "gain") as well as the Q-value thereof. The Q value is expressed by fr/B where the central frequency is fr and B is the peak width at half-height. Also, adjustment circuit 44 is configured so as to be able to independently control the filter gain and the Q value of filter gain for each of filters 43. The fact that each of filters 43 and adjustment circuit 44 have such configurations enables DSP 4 to function as a parametric equalizer.

Audio adjustment device 4 has a characteristic display part displaying the gain characteristics as adjusted by adjustment circuit 44, and in the present embodiment, display 5 is also used as said characteristic display part. Display 5 shows one display of gain characteristics of multiple filters 43A through 43E on one frequency axis. Also, display 5 displays images based on video signals after demodulation, as input from decoder 24.

Remote controller 50 is comprised of operation keys 51, control circuits 52 generating operating signals according to the operation of operation keys 51, and transmission circuit 53 performing wireless transmission to receiving circuit 7 of operating signals generated by control circuit 52. The method of communication between transmission circuit 53 and receiving circuit 7 is infrared communication, but is not limited thereto.

Operating keys 51 (constituting the adjustment part) include display switch key 54, filter key 55, gain key 56, Q value key 57, direction keys 58, enter key 59 and select key 60. Direction keys 58 are comprised of left direction key 58a, right direction key 58b, up direction key 58c, and down direction key 58d.

Display switch key 54 is a key having the purpose of switching the display mode of display 5 between filter characteristics display mode displaying gain characteristics of filters 43, and program display mode displaying broadcast programs.

Filter key 55, gain key 56, Q value key 57, direction keys 58, and enter key 59 are keys having the purpose of adjusting gain characteristics for each separate filter of filters 43 displayed on display 5. Filter key 55, gain key 56, and Q value key 57 are keys having the purpose of respectively selecting whether the item being set for filters 43 is the selection of a filter 43, setting of the gain of the selected filter 43, or setting of the Q value thereof. Direction keys 58 function as keys for performing selection, gain adjustment, or Q value adjustment of a filter 43. Enter key 59 is a key having the purpose of selecting the selection and adjustment made according to direction keys 58. Thus, filter key 55, gain key 56, Q value key 57, direction keys 58, and enter key 59 are configured so as to be able to independently adjust the gain of filters 43 and the Q value of the gain characteristics of filters 43.

Channel select key 60 is a key having the purpose of selecting the channel received by tuner 21 when display 5 is in program display mode.

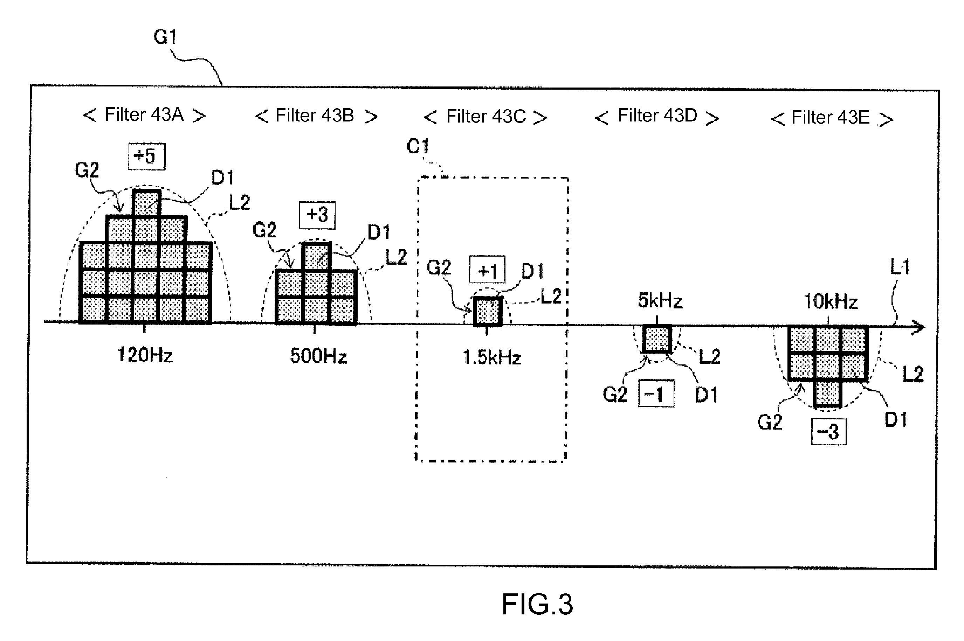

Figure 3 shows a graph of gain characteristics displayed on display 5 in filter characteristic display mode. The horizontal axis of graph G1 thereof indicates frequency, and graph G1 shows gain characteristics G2 of filters 43 with respect to frequency.

In graph G1, gain characteristics G2 are shown in dot format, whereby one dot D1 is comprised of one or more pixels on the display screen of display 5. In graph G1, dots D1 inside the area enclosed by an actual gain characteristic curve L2 of each of filters 43 and a frequency axis L1 are displayed in a different color than dots D1 outside said area, thus gain characteristics G2 are displayed for each of filters 43. Beside the gain characteristic G2 for each of filters 43, it is displayed the degree of relative gain (shown as +5 for filter 43A in Figure 3) or degree of attenuation (displayed as -3 for filter 43E in Figure 3) of each of filters 43. It is also noted that gain characteristic curve L2 is not displayed on the actual display screen, but is shown in Figure 3 for purposes of explanation. Also, the method of display of the degree of amplification or degree of attenuation is not limited to the aforementioned. Also, in the event that the frequency axis (horizontal axis) of graph G1 is a logarithmic display and dots D1 are formed of multiple pixels arrayed in matrix form, the width of dots D1 may be narrowed as the frequency increases.

When filter key 55 is pressed while graph G1 is displayed on display 5, the selection setting of filters 43 is selected as a setting, and cursor C1 indicating the selected filter 43 appears on graph G1. Then, by moving cursor C1 left or right by pressing left key 58a or right key 58b, according to the choice of key operation, and pressing enter key 59, the filter 43 in which cursor C1 is located at that time is determined as the selection.

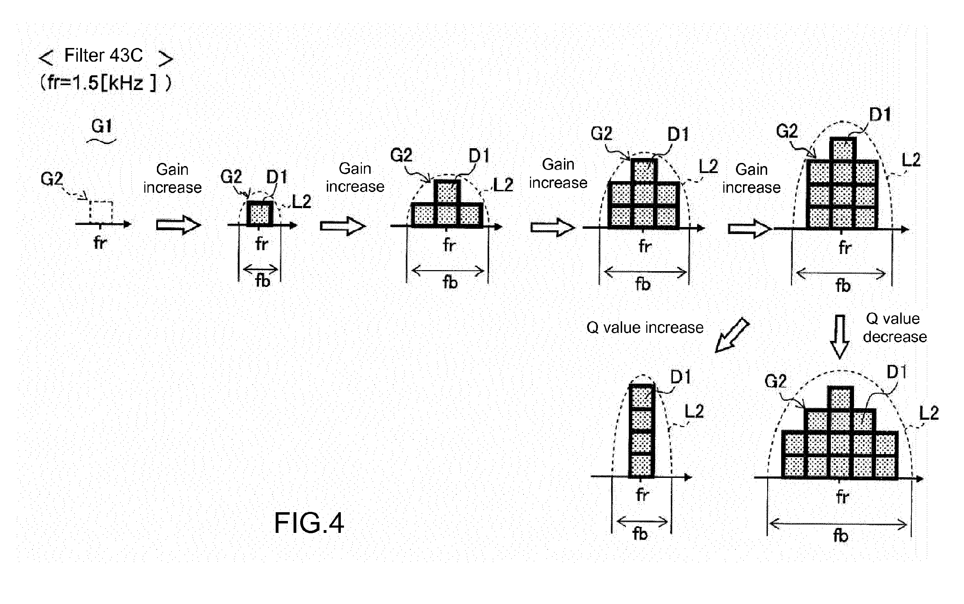

Figure 4 shows changes in gain characteristics G2 from adjustment of gain or Q value of a selected filter 43. Here the description is in regard to gain characteristics G2 of a filter 43 as represented by the choice of filter 43c (fr = 1.5 kHz).

After the gain adjustment is selected by operating gain key 56, if up direction key 58c is operated the gain of filter 43c is increased, and the gain corresponding to central frequency fr on graph G1 also increases. Gain is increased in steps, whereby for example, each time up direction key 58a is pressed, the actual gain is increased by a fixed value, and the gain on graph G1 becomes higher by one dot D1. Although not shown in the drawing, when down direction key 58d is pressed, gain is reduced in the same manner as mentioned above.

As gain increases with respect to central frequency fr, due to the characteristics of filter 43c, gain increases, and frequency band width fb of the amplified or attenuated signal components broadens, with respect to the frequency on the high band side and low band side more than central frequency fr. After adjusting the gain by means of the up direction key 58c or down direction key 58d, enter key 59 is pressed to confirm the adjustment.

When Q value adjustment is selected as the setting item by operating Q value key 57, frequency band width fb of filter 43c is narrowed by operating up direction key 58c, whereby the Q value is increased, and the display on graph G1 changes in the same way. The contraction of frequency bandwidth fb is in steps, so for example the actual frequency bandwidth fb is narrowed by a fixed value with respect to both the high band side and low band side of central frequency fr each time that up direction key 58c is pressed, and the frequency bandwidth fb in the graph G1 is narrowed by one dot D1 with respect to both the high band side and low band side of central frequency fr. When down direction key 58d is pressed, frequency bandwidth fb is broadened in steps in the same manner as described above, and the Q value is also reduced in steps accordingly. After adjusting the Q value by operating up direction key 58c and down direction key 58d, enter key 59 is pressed to confirm the adjustment.

In the present embodiment, the user can directly confirm the gain and Q value of each of filters 43 from the gain characteristics G2 of each of filters 43 as displayed on display 5. The user can also adjust the gain and Q value using remote control 50 while viewing gain characteristics G2 on the display, and thus adjustment operations are made simpler. In addition, the display of gain characteristics G2 on display 5 shows gain characteristics G2 of all filters 43 along one frequency axis, thereby making it easy to ascertain the balance among gain characteristics G2 of all filters 43, and thereby it is easy to understand the overall balance in each frequency band of the audio after adjustment by means of audio adjustment device 4.

Also, because display 5 displays broadcast programs and is also used as a characteristic display part indicating on one general display the gain characteristics G2 of each filter 43, in the event of a large number of filters 43, even if frequency bands of signal components subject to amplification or attenuation by filters 43 are broadened, it is still possible to display gain characteristics G2 of each filter 43 in a large display size, thereby making it easy for the user to view the gain characteristics G2. In addition, it is possible to decrease the number of display devices, and thus to achieve size and cost reduction.

In addition, whenever adjusting the Q value of any of filters 43, even if the frequency bands of signal components subject to amplification or attenuation overlap with those of other filters with nearby central frequencies, it is easier to notice the overlap than in prior art hereby gain characteristics of each filter were displayed by individually switching.

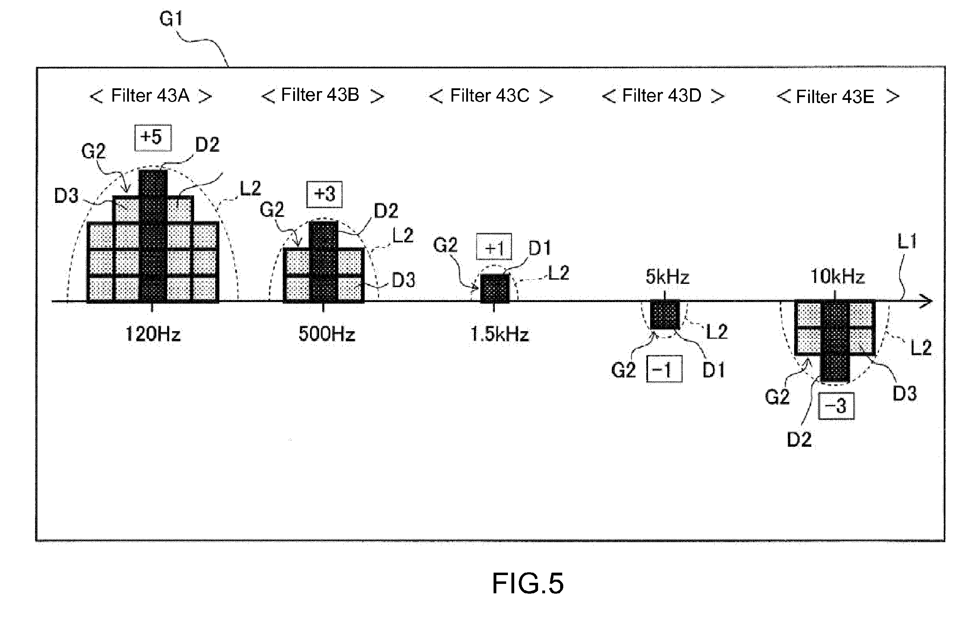

Next, a TV receiver according to another example of the aforementioned embodiment is described. Figure 5 shows a graph G1 of the embodiment. In graph G1 according to this embodiment, a given color is assigned to dots D2 indicating gain in relation to central frequency fr, and the same color with a different intensity than dots D2, or a different color than dots D2, is assigned to dots D3 indicating gain with respect to frequencies other than central frequency fr, and thus the dots are distinguished by color. In the event that the difference between dots D2 and D3 is only a difference of intensity, the color of dots D2 may be set so as to appear more intense than the color of dots D3. In the present example, it is easy to visual confirm the breadth of dots D3 with reference to dots D2 by means of the coloration of dots, and thus the Q values of gain characteristics G2 of each filter 43 are even easier to directly ascertain.

It is also noted that the present invention is not limited to the configurations of the aforementioned embodiments, and may be altered in a variety of ways according to the purpose of use. For example, the central frequencies of each filter may be made variable by operation of operating keys on the remote control. Also, operating keys may be placed on the TV receiver body. Also it is possible to connect to video/audio playback devices such as a DVD/BD (Blu-ray Disc) player, and to display the image signal input from said video/audio playback device on the display.

### Explanation of reference numbers

- 1...: television receiver
- 2...: broadcast receiving circuit (broadcast receiving part)
- 4...: audio adjustment device
- 43, 43A through 43E: filter
- 44...: adjustment circuit (comprising adjustment part)
- 5...: display (characteristic display part, video display part)
- 50...: remote controller
- 51...: operating keys (comprising adjustment part)
- fr...: central frequency
- D1...: dot
- D2...: dot indicating gain with respect to central frequency
- D3...: dot indicating gain with respect to frequency other than central frequency

## Claims

1. An audio adjustment device (4), comprising:
a plurality of filters (43) respectively amplifying or attenuating signal components of a multiplicity of frequency bands among input audio components;
an adjustment part (44) that adjusts gain characteristics of the plurality of filters (43); and
a characteristic display part (5) that displays gain characteristics (G2) adjusted by the adjustment part (44), wherein
the adjustment part (44) is capable of independently adjusting:
gain in signal components of central frequencies (fr) of signal components subject to amplification or attenuation by the filters (43), and
Q value of gain characteristics (G2) of the filters (43), and
the characteristic display part (5) displays the gain characteristics (G2) of the plurality of filters (43) in a row along one frequency axis (L1).

2. The audio adjustment device (4) according to Claim 1, wherein
the characteristics display part (5) displays the gain characteristics in dot format,
dots (D1) contained within an area between gain characteristic curves of each of the filters (43) and the frequency axis (L1) are displayed in a different color than dots (D1) outside said area, and
dots (D2) indicating gain with respect to the central frequencies (fr) are assigned a given color whereas dots (D3) indicating gain with respect to frequencies other than the central frequencies (fr) are assigned a same color with a different intensity than the dots (D2) of the central frequencies (fr), or are assigned a separate color than the dots (D2) of the central frequencies (fr).

3. A television device (1) comprising:
an audio adjustment device (4) according to claim 1 or claim 2, and
a video display part (5) displaying images according to input video signals, wherein the video display part (5) is also used as the characteristic display part (5).
